# DEMANDE DE BREVET EUROPEEN

(11) **EP 0 714 138 A1**
(43) Date de publication de la demande: **29.05.1996**
(21) Numéro de dépôt: 95402617.5
(22) Date de dépôt: 21.11.1995
(51) Int. Cl.: H01L 29/737

(54) **Amplificateur hyperfréquence monolithique haute intégration, à topologie distribuée arborescente**

(30) Priorité: 25.11.1994 FR 9414148
(71) Demandeur: THOMSON-CSF, 75008 Paris (FR)
(72) Inventeur: Floriot, Didier, Thomson-CSF, F-92402 Courbevoie Cedex (FR); Delage, Sylvain, Thomson-CSF, F-92402 Courbevoie Cedex (FR); Roux, Pascal, Thomson-CSF, F-92402 Courbevoie Cedex (FR); Obregon, Juan, Thomson-CSF, F-92402 Courbevoie Cedex (FR)
(74) Mandataire: Guérin, Michel

(57) **Abrégé**

L'invention concerne une nouvelle topologie d'amplificateur hyperfréquence monolithique, à haute intégration.

Il s'agit d'une topologie plus compacte, divisée à deux niveaux ou arborescente dans laquelle la division du signal d'entrée s'effectue d'une part sur chaque transistor Tij, d'autre part sur chacun des transistors élémentaires tijk des transistors Tij. Plus précisément, la ligne d'entrée LE est divisée en différentes lignes de base li, chaque ligne li alimentant des lignes lij distribuées de part et d'autre desdites lignes li, une ligne lij alimentant alors un transistor de puissance Tij.

Application: Amplificateur hyperfréquence.

## Description

Le domaine de l'invention est celui des amplificateurs hyperfréquence de forte puissance, monolithiques intégrés encore dénommés (MMIC) sur substrat semiconducteur et notamment sur GaAs.

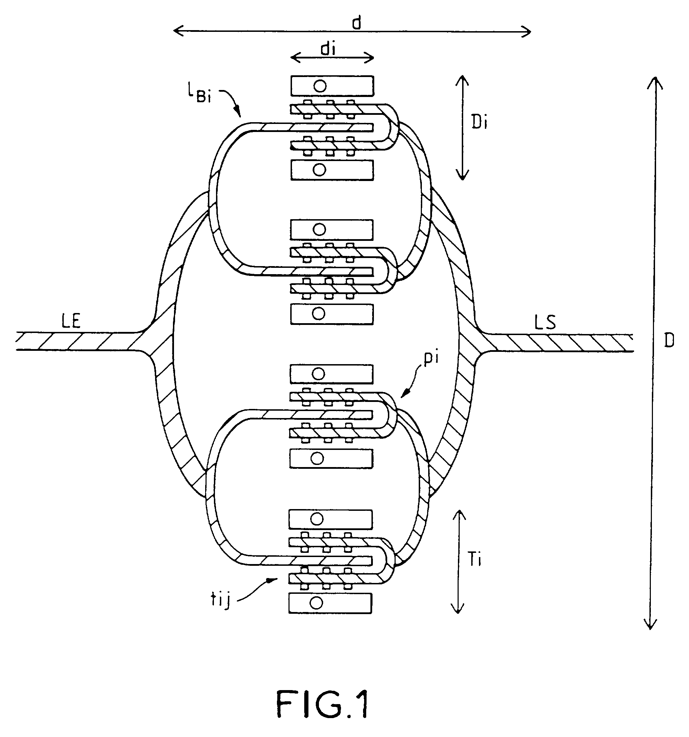

Généralement de tels amplificateurs résultent de la combinaison d'ensemble de transistors élémentaires montés en parallèle, que l'on cherche à intégrer sur des surfaces limitées. Une des topologies actuellement adoptée est celle illustrée figure 1 qui schématise les différents transistors de puissance Ti avec leurs transistors élémentaires tij montés en parallèle de part et d'autre d'une ligne de base l_{Bi}, comportant des connexions avec les bases élémentaires des transistors élémentaires. Ces différentes lignes l_{Bi} sont connectées entre elles à la ligne d'entrée principale LE. Les émetteurs des transistors élémentaires sont quant à eux reliés à une zone commune comportant des via, au travers du substrat semiconducteur, de manière à connecter les émetteurs à un plan de masse situé à l'arrière du substrat. Les collecteurs élémentaires sont reliés entre eux par des ponts collecteurs pi reliés entre eux à une ligne de sortie LS.

Pour obtenir des effets cumulatifs et atteindre des puissances très élevées en sorite, il est impératif de diviser le signal d'entrée de manière la plus symétrique possible, puis de le recombiner également de manière très symétrique. En effet, si une telle condition n'est pas respectée, des problèmes de déphasage nuisent à la sommation des amplificateurs élémentaires au niveau de chaque transistor Ti. Il apparaît cependant que ce type de topologie telle que schématisée en figure 1 présente deux types d'inconvénients :
- d'une part la difficulté d'intégration d'un grand nombre de transistors élémentaires sur une surface donnée en raison de la dimension D proportionnelle au nombre de transistors de puissance mis en parallèle ;
- d'autre part l'augmentation des pertes dans les circuits d'adaptation d'impédance situés entre l'entrée et les transistors, ainsi qu'entre ces transistors et la sortie. Ces pertes étant d'autant plus importantes qu'elles sont relatives à des transistors situés loin des lignes d'entrée et de sortie LE et LS.

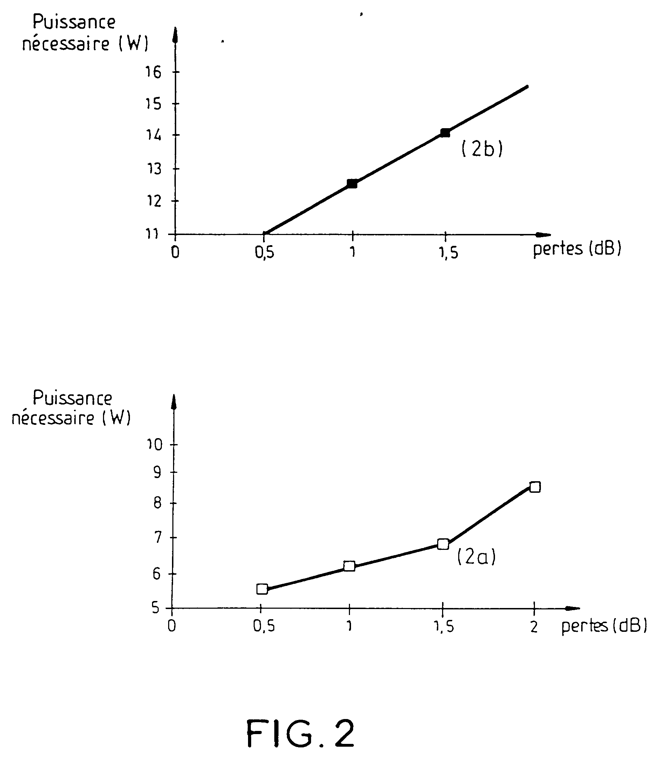

A titre indicatif, la figure 2 fournit pour des puissances de sortie respectivement 5W (figure 2a) et 10W (figure 2b) les puissances nécessaires devant être fournies par l'ensemble des transistors compte tenu des pertes dans le réseau de sortie. Ainsi des pertes de 2dB entraîne une perte de 30 % de puissance dans le réseau d'adaptation d'où un sévère problème de dissipation thermique sur la partie concernée du substrat.

Typiquement en technologie monolithique sur GaAs les pertes sont comprises entre 0,5 et 1,5 dB et donc font chuter de manière sensible la puissance récupérée au niveau de la ligne LS.

Afin de diminuer la dimension D de l'amplificateur de puissance représentée en figure 1 et limiter les pertes en ligne d'amplificateurs de puissance, l'invention propose un composant plus compact, présentant une topologie originale permettant d'intégrer un grand nombre de transistors de puissance dans un encombrement restreint et permettant d'éviter de grandes longueurs de ligne.

Dans la topologie proposée, la dimension critique Di d'un transistor de puissance Ti effectue une rotation de 90° par rapport à la configuration de l'art antérieur représenté en figure 1. Cette dimension Dᵢ devient ainsi parallèle à l'axe entrée-sortie du composant hyperfréquence.

Pour mettre en oeuvre cette rotation, la topologie utilisée dans l'invention peut être comparée à une structure divisée à deux niveaux ou arborescente, car la division du signal d'entrée s'effectue :
- sur chaque transistor de puissance Tij
- sur chacun des transistors élémentaires tijk des transistors Tij.

Plus précisément, l'invention a pour objet un composant semiconducteur de puissance, alimenté par une ligne d'entrée LE et comprenant n transistors de puissance Tij, chaque transistor Tij comportant mᵢⱼ transistors élémentaires tijk mis en parallèle de chaque côté d'une ligne d'entrée de base lij, caractérisé en ce que la ligne LE est divisée en lignes parallèles li, de part et d'autre desquelles lignes li sont distribuées les lignes lij qui alimentent les transistors Tij.

Pour augmenter encore la compacité de l'ensemble, chaque transistor de puissance Tij peut mettre en commun avec son(ses) plus proches(s) voisin(s) un émetteur Eij assurant la liaison entre les émetteurs eijk des transistors tijk d'un même transistor Tij.

La topologie selon l'invention peut avantageusement présenter des circuits d'adaptation d'impédance entre les lignes de propagation et les entrées ou sorties des transistors de puissance, ces réseaux de propagation d'adaptation permettant par ailleurs de compenser les déphasages créés lors de la distribution du courant de base à partir d'une ligne li dans les différentes lignes de base lij.

De préférence, ces circuits d'adaptation d'impédance entre chaque transistor Tij sont introduits dans les espaces libres, connectés entre les émetteurs et les lignes li, ceci n'entraînant en aucune façon la diminution de la compacité de la topologie arborescente proposée dans l'invention.

L'invention sera mieux comprise et d'autres avantages apparaîtront à la lecture de la description qui va suivre donnée à titre non limitatif et des figures annexées parmi lesquelles :
- la figure 1 schématise une configuration d'amplificateur de puissance selon l'art antérieur ;
- la figure 2 illustre les puissances à fournir par l'ensemble des transistors de puissance pour obtenir respectivement 5W (courbe 2a) et 10W (courbe 2b) en fonction des pertes sur le circuit d'adaptation de sortie ;
- la figure 3 schématise une topologie de composant de puissance selon l'invention.

L'invention propose une nouvelle topologie de composant semiconducteur de puissance, s'appliquant particulièrement aux amplificateurs (MMIC). Ceci sont élaborés par intégration sur substrat pouvant avantageusement être de type AsGa.

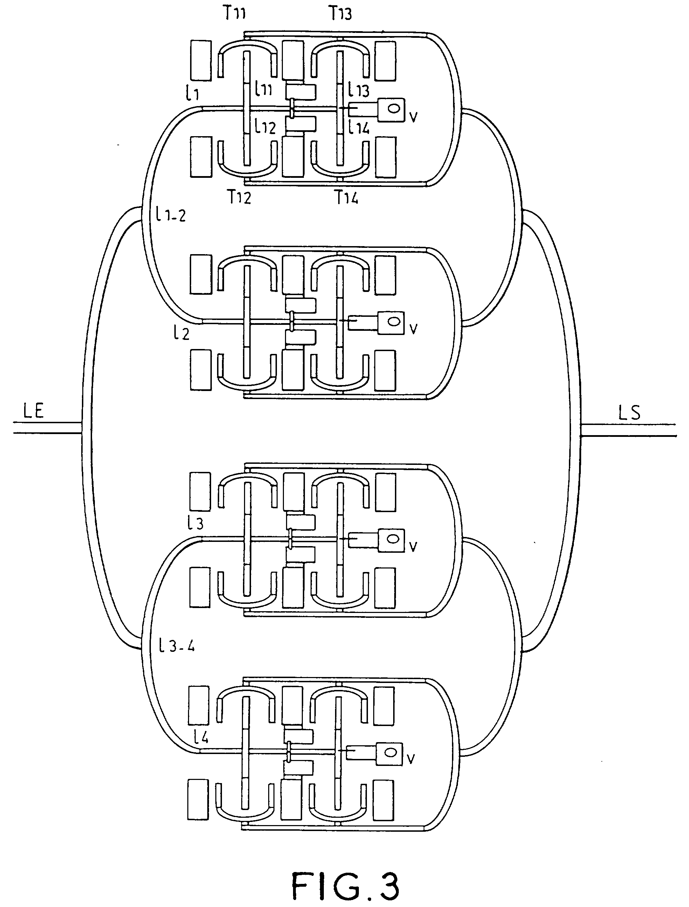

Ainsi sur un substrat donné on peut définir une cellule de puissance comprenant un ensemble de transistors élémentaires, tijk dont on cherche à additionner les gains en puissance. Pour cela la topologie adoptée est celle schématisée en figure 3 dans laquelle seul un nombre restreint de transistors tijk ont été représentés. Ces transistors élémentaires peuvent être des transistors bipolaires à hétérojonction particulièrement performants pour des applications de puissance.

Les différents transistors tijk sont répartis en plusieurs transistors de puissance Tij, autour de lignes de base lij venant alimenter lesdits transistors Tij, répartis de part et d'autre des lignes li. Les lignes de base sont connectées entre elles deux à deux, la figure 3 illustre à ce titre la connexion par exemple des lignes l₁ et l₂ en une ligne commune l₁₋₂, une telle division du signal d'entrée favorisant la mise en phase des différents transistors de puissance.

Avec ce type de topologie il est aussi possible d'élaborer des cellules à intégration horizontale d'ordre N (N transistors Tij le long d'une ligne) et à intégration verticale d'ordre M (2M transistors Tij selon l'axe vertical Y, puisque le long des lignes li sont distribués de part et d'autre des transistors Tij).

Cependant, même s'il existe une symétrie horizontale, il n'existe pas de symétrie verticale, les courants de base circulant dans une ligne lij et dans une ligne voisine li j+2 ne sont pas en phase.

Pour compenser ces déphasages, des circuits (LC) d'adaptation Zij sont introduits au niveau des différentes lignes li, ces circuits Zij sont constitués par des longueurs et des largeurs de lignes adaptées ainsi que par des condensateurs de capacité calculée. Plus précisément, les condensateurs sont constitués d'une couche diélectrique comprise entre deux armatures métalliques, l'armature supérieure est connectée à la ligne de base, l'armature inférieure est connectée à la zone émettrice qui comporte un via, assurant la mise à la masse.

Au niveau de chaque transistor Ti, on peut si on le désire mettre en parallèle des transistors possédant des caractéristiques de puissance différente, c'est-à-dire un nombre variable de transistors élémentaires.

Une telle configuration : mise en parallèle d'un ensemble de transistors de puissance selon un axe vertical et distribution de transistors de puissance le long d'une ligne de base li, permet de conjuguer les performances de puissance des amplificateurs dans lesquels les transistors sont montés en parallèle et la largeur de bande obtenue avec une configuration d'amplificateur distribué.

Le tableau I ci-dessous illustre ainsi les performances que l'on peut obtenir dans les trois configurations précitées :

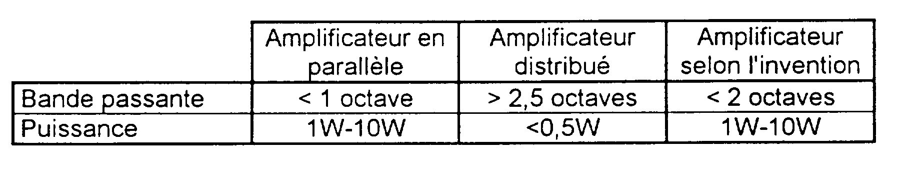

1 octave correspondant à la gamme de fréquence (fo - 2fo) :

Pour comparer la compacité d'une topologie selon l'invention avec une configuration classique de transistors mis en parallèle, le tableau II indique les dimensions nécessaires Dx et Dy selon respectivement les axes X et Y fournis en figure 1, pour obtenir des puissances respectivement de 2,5W, 5W et 10W.

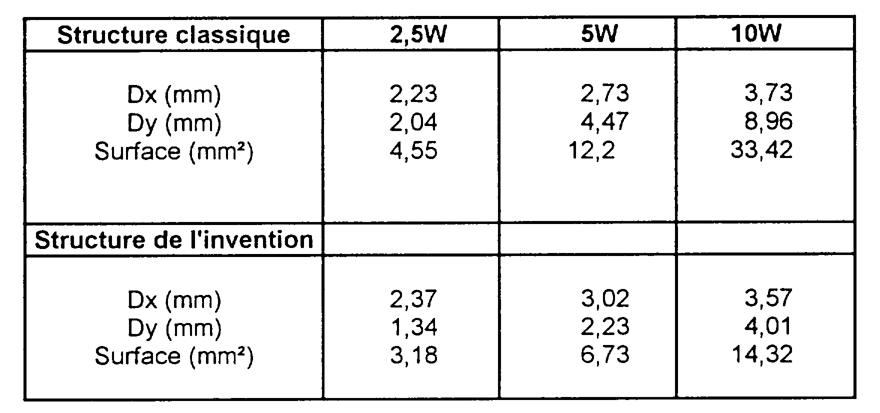

## Revendications

1. Composant semiconducteur de puissance, alimenté par une ligne d'entrée LE et comprenant n transistors de puissance Tij, chaque transistor Tij comportant mᵢⱼ transistors bipolaires élémentaires tijk mis en parallèle de chaque côté d'une ligne d'entrée de base lij, caractérisé en ce que la ligne LE est divisée en lignes parallèles li, de part et d'autres desquelles lignes li sont distribuées les lignes lij qui alimentent les transistors Tij.

2. Composant semiconducteur de puissance selon la revendication 1, caractérisé en ce que les sorties des transistors élémentaires tijk sont reliées entre elles par des ponts collecteur Pij, lesdits ponts étant distribués de part et d'autre des lignes li, les ponts d'un même côté d'une ligne li étant relié par une ligne de sortie Lpi, les différentes lignes Lpi étant reliées à une ligne commune de sortie LS.

3. Composant semiconducteur de puissance selon l'une des revendications 1 ou 2, caractérisé en ce que les transistors de puissance Tij ont en commun avec leur(s) plus proche(s) voisin(s) des émetteurs Eij permettant de relier les émetteurs eijk des transistors tijk d'un même transistor de puissance Tij.

4. Composant semiconducteur de puissance selon l'une des revendications 1 à 3, caractérisé en ce qu'il comprend des circuits d'adaptation d'impédance composés de condensateurs connectés entre les lignes li et les émetteurs Eij.

5. Composant semiconducteur de puissance, caractérisé en ce que les transistors sont élaborés sur substrat GaAs.
